# EUROPEAN PATENT APPLICATION

(11) **EP 4 841 293 A1**
(43) Date of publication of application: **18.11.2026**
(21) Application number: 24917037.4
(22) Date of filing: 16.12.2024
(51) Int. Cl.: G01S 5/14, G01R 33/02

(54) **ANTENNA SETTING METHOD AND POSITIONING SYSTEM USING SAME**

(30) Priority: 10.01.2024 JP 2024001851
(71) Applicant: OMRON Corporation, Kyoto-shi, Kyoto 600-8530 (JP)
(72) Inventor: NAMOSE Isamu, Kyoto-shi, Kyoto 600-8530 (JP)
(74) Representative: Marks & Clerk LLP
(86) International application number: PCT/JP2024/044354
(87) International publication number: WO 2025/150353

(57) **Abstract**

Provided are an antenna setting method for appropriately setting three antennas used in a positioning system and a positioning system using the same. An antenna setting method M100 includes: a first step S110 of setting, based on the reception strengths, an intermediate position at which the reception strengths from the second antenna 13B and the third antenna 13C are equal as a calibration origin O; a second step S120 of installing, based on the reception strengths, a first antenna 13A at a first position at which distances from the second antenna 13B and the third antenna 13C are equal; a third step S130 of calculating, based on the reception strengths, a first distance d1 from the calibration origin O to the first antenna 13A, a second distance d2 from the calibration origin O to the second antenna 13B, and a third distance d3 from the calibration origin O to the third antenna 13C; and a fourth step S140 of setting, based on the first distance d1, the second distance d2, and the third distance d3, coordinate data of installation positions of the first antenna 13A, the second antenna 13B, and the third antenna 13C.

## Description

### TECHNICAL FIELD

The present invention relates to an antenna setting method and a positioning system using the same.

### BACKGROUND OF INVENTION

In the related art, various techniques related to indoor positioning are known as systems for determining a position of a worker working in a factory.

Typically, a positioning system is known in which, for example, a target equipped with a sensor device receives radio waves from three antennas and is positioned based on strengths of the respective radio wave. A positioning system is also known in which magnetic fields are generated by three antennas and based on strengths of the respective magnetic fields received by a target equipped with a magnetic sensor, the target is positioned.

In these positioning systems, coordinate data of installation positions of three antennas that generate radio waves or magnetic fields are set in advance, and based on the radio wave strengths or the magnetic field strengths received by the target equipped with the sensor device distances between the target and the respective antennas are calculated, thereby positioning the target.

### CITATION LIST

### PATENT LITERATURE

Patent Document 1: JP 2013-145193 A

### SUMMARY

### TECHNICAL PROBLEM

However, in the known positioning system, for an antenna that generates radio waves or magnetic fields, an error may occur between coordinate data of an installation position of an antenna set in advance and a position of a source of the radio waves or magnetic field generated by the antenna. For example, when a tip end portion or a central portion of the antenna is set as the source of the radio waves or magnetic fields and the position of the tip end portion or the central portion physically measured is set in advance as the coordinate data of the installation position of the antenna, an error may occur between the coordinate data of the installation position of the antenna and the position of the source of the radio waves or magnetic fields originally generated from the antenna.

That is, when the distance between the target and the antenna is calculated based on the radio wave strength or the magnetic field strength received by the target equipped with the sensor device, there is a problem that the target cannot be positioned with high accuracy due to the error.

Patent Document 1 discloses a method related to a method for positioning a three axis magnetic field sensor of a magnetic field measuring device, and in the method, the magnetic sensor is set such that distances between the magnetic sensor and two points are equal, but does not disclose a method for appropriately installing three antennas in the positioning system.

Thus, an object of the present invention is to provide an antenna setting method for appropriately setting three antennas used in the positioning system, and a positioning system using the same.

### SOLUTION TO PROBLEM

An antenna setting method according to one aspect of the present invention is an antenna setting method for setting a first antenna, a second antenna, and a third antenna used in a positioning system and includes: a first step of setting, based on reception strengths from the second antenna and the third antenna received by a sensor device, an intermediate position at which the reception strengths from the second antenna and the third antenna are equal as a calibration origin; a second step of moving the sensor device from the calibration origin and installing, based on the reception strengths from the second antenna and the third antenna received by the sensor device, the first antenna at any first position at which the reception strengths from the second antenna and the third antenna are equal and distances from the second antenna and the third antenna are equal; a third step of moving the sensor device to the calibration origin and calculating, based on the reception strengths from the first antenna, the second antenna, and the third antenna, a first distance from the calibration origin to the first antenna, a second distance from the calibration origin to the second antenna, and a third distance from the calibration origin to the third antenna; and a fourth step of setting, based on the first distance, the second distance, and the third distance, coordinate data of installation positions of the first antenna, the second antenna, and the third antenna.

In this aspect, in the first step, the intermediate position at which the reception strengths from the second antenna and the third antenna are equal is set as the calibration origin, in the second step, the sensor device is moved from the calibration origin, and the first antenna is installed at any first position at which the distances from the second antenna and the third antenna are equal, in the third step, the sensor device is moved to the calibration origin, and the distances from the calibration origin to the first antenna, the second antenna, and the third antenna are calculated, and in the fourth step, the coordinate data of the installation positions of the first antenna, the second antenna, and the third antenna are set based on the first distance, the second distance, and the third distance. Accordingly, the coordinate data of the installation positions of the first antenna, the second antenna, and the third antenna can be appropriately set based on the reception strengths from the first antenna, the second antenna, and the third antenna received by the sensor device. As a result, in the positioning system including the first antenna, the second antenna, and the third antenna, unlike the coordinate data of the installation positions based on the physically measured distances, the position of the source of the radio waves or magnetic fields is set from the distance calculated based on the reception strengths received from the antennas, thereby positioning the target equipped with a receiving device with high accuracy.

In the above aspect, the first step may include setting a position at which the reception strengths from the second antenna and the third antenna received by the sensor device are equal and minimal as the calibration origin.

This aspect allows, in the first step, an intermediate position at which the reception strengths from the second antenna and the third antenna are equal to be more appropriately set as the calibration origin.

In the above aspect, the second step may include searching for the first position while moving the sensor device in a direction orthogonal to a straight line connecting the second antenna and the third antenna.

This aspect allows, in the second step, the reception strengths from the second antenna and the third antenna to be more appropriately made equal. That is, the first position at which distances from the second antenna and the third antenna are equal can be searched for, and the first antenna can be installed.

The above aspect may further include: assuming that the first antenna, the second antenna, and the third antenna are installed at the coordinate data of the installation positions set in the fourth step, a fifth step of positioning a target equipped with the sensor device at two different points in a direction orthogonal to an assumed plane including the first antenna, the second antenna, and the third antenna; and a sixth step of determining, based on position information of the two different points positioned in the fifth step, a deviation of the coordinate data of the installation position set as the position at which the first antenna is installed.

In this aspect, in the fifth step, the target equipped with the sensor device is positioned at the two different points in the direction orthogonal to the assumed plane including the first antenna, the second antenna, and the third antenna, and in the sixth step, the deviation of the coordinate data of the installation position set as the position at which the first antenna is installed is determined based on the position information of the two different points, thereby appropriately confirming the accuracy of the coordinate data of the installation positions of the first antenna, the second antenna, and the third antenna.

The above aspect may further include when it is determined that there is a deviation in the coordinate data of the installation position set as the position at which the first antenna is installed in the sixth step, a seventh step of correcting, based on the position information of the two different points positioned in the fifth step, a direction orthogonal to the assumed plane in the coordinate data of the installation position set as the position at which the first antenna is installed.

In this aspect, the direction orthogonal to the assumed plane in the coordinate data of the installation position of the first antenna is corrected based on the position information of the two different points in the seventh step when it is determined that there is a deviation in the coordinate data of the installation position of the first antenna, thereby more appropriately setting the coordinate data of the installation positions of the first antenna, the second antenna, and the third antenna. As a result, in the positioning system including the first antenna, the second antenna, and the third antenna, the target equipped with the receiving device can be positioned with higher accuracy.

The above aspect may further include: assuming that the first antenna, the second antenna, and the third antenna are installed at the coordinate data of the installation positions set in the fourth step, a fifth step of positioning a target equipped with the sensor device at two different points in a direction parallel to an assumed plane including the first antenna, the second antenna, and the third antenna; and a sixth step of determining, based on position information of the two different points positioned in the fifth step, a deviation of the coordinate data of the installation positions set as the positions at which the second antenna and the third antenna are installed.

In this aspect, in the fifth step, the target equipped with the sensor device is positioned at the two different points in the direction parallel to the assumed plane including the first antenna, the second antenna, and the third antenna, and in the sixth step, the deviation of the coordinate data of the installation positions of the second antenna and the third antenna is determined based on the position information of the two different points, thereby appropriately confirming the accuracy of the coordinate data of the installation positions of the first antenna, the second antenna, and the third antenna.

The above aspect may further include when it is determined that there is a deviation in the coordinate data of the installation position set as the positions at which the second antenna and the third antenna are installed in the sixth step, a seventh step of correcting, based on the position information of the two different points positioned in the fifth step, a direction orthogonal to the assumed plane in the coordinate data of the installation position set as the positions at which the second antenna and the third antenna are installed.

In this aspect, when it is determined that there is a deviation in the coordinate data of the installation positions of the second antenna and the third antenna, in the seventh step, the direction orthogonal to the assumed plane in the coordinate data of the installation positions of the second antenna and the third antenna is corrected based on the position information of the two different points, thereby more appropriately setting the coordinate data of the installation positions of the first antenna, the second antenna, and the third antenna. As a result, in the positioning system including the first antenna, the second antenna, and the third antenna, the target equipped with the receiving device can be positioned with higher accuracy.

In the above aspect, the first antenna, the second antenna, and the third antenna each may include a coil configured to generate a magnetic field, and the sensor device may include a coil capable of receiving magnetic fields generated by the first antenna, the second antenna, and the third antenna.

This aspect enables the sensor device, as a magnetic sensor device, to calculate the distances to the antennas based on the magnetic field strengths received from the first antenna, the second antenna, and the third antenna, thereby appropriately setting the positions of the sources of the magnetic fields in the first antenna, the second antenna, and the third antenna as the coordinate data of the installation positions of the first antenna, the second antenna, and the third antenna, respectively.

A positioning system according to an aspect of the present invention positions the target equipped with the sensor device capable of receiving the radio waves or the magnetic fields from the first antenna, the second antenna, and the third antenna set by the antenna setting method.

This aspect enables the target equipped with the sensor device to be positioned using the first antenna, the second antenna, and the third antenna in which the coordinate data of the installation positions are appropriately set by the antenna setting method, thereby positioning the target equipped with the receiving device with high accuracy.

### ADVANTAGEOUS EFFECTS OF INVENTION

The present invention provides an antenna setting method for appropriately setting three antennas used in a positioning system and a positioning system using the same.

### BRIEF DESCRIPTION OF THE DRAWINGS

FIG. 1 is a system configuration diagram illustrating an outline of a positioning system 1 according to a first embodiment of the present invention.
FIG. 2 is a functional block diagram illustrating functions of an antenna setting system 100 corresponding to procedures of an antenna setting method according to the first embodiment of the present invention.
FIG. 3 is a diagram illustrating a state in which an intermediate position at which reception strengths from a second antenna 13B and a third antenna 13C are equal is set as a calibration origin O.
FIG. 4 is a diagram illustrating a state in which the first antenna 13A is installed at any position at which distances from the second antenna 13B and the third antenna 13C are equal.
FIG. 5 is a diagram illustrating a state in which a first distance d1 to the first antenna 13A from the calibration origin O, a second distance d2 to the second antenna 13B from the calibration origin O, and a third distance d3 to the third antenna 13C from the calibration origin O are calculated.
FIG. 6 is a flowchart illustrating a flow of processing of an antenna setting method M100 according to a first embodiment of the present invention.
FIG. 7 is a diagram illustrating a state in which a target equipped with a receiving TAG 21 is positioned using the first antenna 13A, the second antenna 13B, and the third antenna 13C.
FIG. 8 is a diagram illustrating a specific example in which the coordinate data of the installation position of the first antenna 13A set using the antenna setting method described in the first embodiment are offset in the Z-axis direction.
FIG. 9 is a diagram illustrating another specific example in which the coordinate data of the installation position of the first antenna 13A set using the antenna setting method described in the first embodiment are offset in the Z-axis direction.

### DESCRIPTION OF EMBODIMENTS

Hereinafter, each preferred embodiment of the present invention will be described in detail with reference to the drawings. Note that each embodiment described below is merely a specific example for implementing the present invention, and shall not limit the interpretation of the present invention. In addition, in order to facilitate understanding of the description, the same components in the drawings are denoted by the same reference signs as much as possible, and duplicate descriptions may be omitted.

### First Embodiment

### Configuration of Positioning System

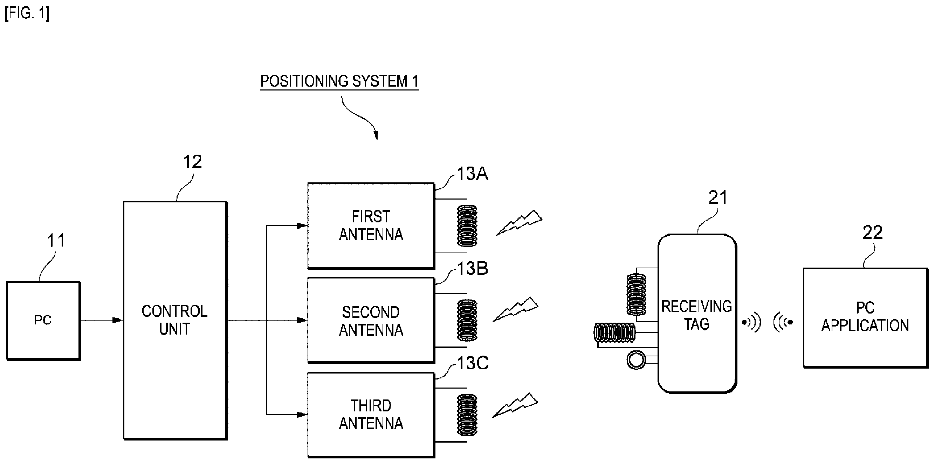

FIG. 1 is a system configuration diagram illustrating an outline of a positioning system 1 according to a first embodiment of the present invention. As illustrated in FIG. 1, the positioning system 1 includes a personal computer (PC) 11 on a transmitting side, a control unit 12, a first antenna 13A, a second antenna 13B, a third antenna 13C, a receiving TAG (sensor device) 21, and a PC 22 on a receiving side.

The PC 11 on the transmitting side sends instructions regarding driving of the first antenna 13A, the second antenna 13B, and the third antenna 13C to the control unit 12. For example, the PC 11 on the transmitting side may send, to the control unit 12, a drive pattern including drive timings for generating magnetic fields in the first antenna 13A, the second antenna 13B, and the third antenna 13C and magnetic field strengths.

The control unit 12 drives the first antenna 13A, the second antenna 13B, and the third antenna 13C to generate the magnetic fields based on the drive pattern from the PC 11 on the transmitting side. To be specific, the control unit 12 performs control to flow currents through coils in the first antenna 13A, the second antenna 13B, and the third antenna 13C to generate the magnetic fields in the first antenna 13A, the second antenna 13B, and the third antenna 13C in order.

The receiving TAG 21 receives the magnetic fields from the first antenna 13A, the second antenna 13B, and the third antenna 13C. For example, the receiving TAG 21 includes three axis coils disposed in the X-axis, Y-axis, and Z-axis directions, and receives the magnetic fields from the first antenna 13A, the second antenna 13B, and the third antenna 13C by the three axis coils.

The receiving TAG 21 includes a micro controller unit (MCU), and calculates the magnetic field strength from each of the first antenna 13A, the second antenna 13B, and the third antenna 13C. For example, the magnetic field strength (RSSI: Received Signal Strength Indicator) in the receiving TAG 21 may be calculated by √(RSSI_x² + RSSI_y² + RSSI_z²) by combining RSSI_x of an X-axis component, RSSI_y of a Y-axis component, and RSSI_z of a Z-axis component in the three axis coils.

The receiving TAG 21 calculates the magnetic field strengths (RSSI) from the first antenna 13A, the second antenna 13B, and the third antenna 13C, and transmits the magnetic field strengths to the PC 22 on the receiving side via a wireless network such as Bluetooth (registered trade mark).

The PC 22 on the receiving side calculates, based on the magnetic field strengths (RSSIs) from the first antenna13A, the second antenna 13B, and the third antenna 13C calculated by the receiving TAG 21, the distances between the receiving TAG 21 and the first antenna 13A, between the receiving TAG 21 and the second antenna 13B, and between the receiving TAG 21 and the third antenna 13C.

To be specific, an application is installed in the PC 22 on the receiving side, and the distances between the receiving TAG 21 and the first antenna 13A, between the receiving TAG 21 and the second antenna 13B, and between the receiving TAG 21 and the third antenna 13C are calculated based on the characteristic that the magnetic field strength (RSSI) attenuates with the cube of the distance. Then, the receiving TAG 21 may be positioned by the application based on the distances from the first antenna 13A, the second antenna 13B, and the third antenna 13C.

In the above description, the magnetic field strengths (RSSIs) are calculated by the MCU in the receiving TAG 21, and the distances between the receiving TAG 21 and the first antenna 13A, between the receiving TAG 21 and the second antenna 13B, and between the receiving TAG 21 and the third antenna 13C are calculated by the application in the PC 22 on the receiving side, but the embodiment is not limited thereto. For example, all or a part of the magnetic field strengths (RSSIs) calculated by the MCU in the receiving TAG 21 may be calculated by the application in the PC 22 on the receiving side, or conversely, the distances calculated by the application in the PC 22 on the receiving side may be calculated by the MCU in the receiving TAG 21.

The application is installed in the PC 22 on the receiving side, but not limited to the PC, and may be installed in a mobile terminal or the like equipped with a receiving TAG 21, and the receiving TAG 21 and the application may be integrated. In this case, a screen for displaying a positioning result of the receiving TAG 21 may be provided in the mobile terminal or the like, or a display device for separately displaying the positioning result may be provided.

### [Antenna Setting Method]

In the positioning system 1 described with reference to FIG. 1, it is necessary to set the first antenna 13A, the second antenna 13B, and the third antenna 13C in advance. Hereinafter, an antenna setting method for setting the first antenna 13A, the second antenna 13B, and the third antenna 13C will be described in detail.

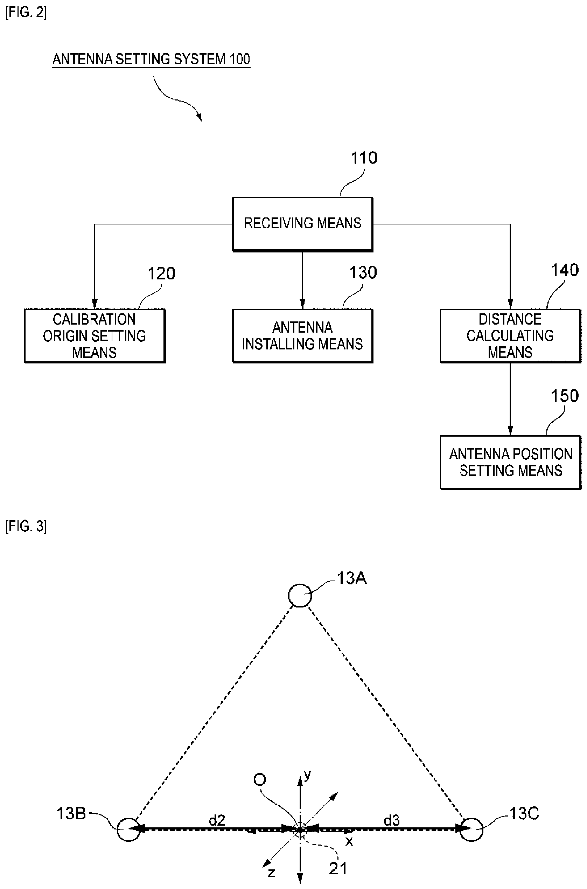

FIG. 2 is a functional block diagram illustrating functions of an antenna setting system 100 corresponding to procedures of an antenna setting method according to the first embodiment of the present invention. As illustrated in FIG. 2, the antenna setting system 100 includes a receiving means 110, a calibration origin setting means 120, an antenna installing means 130, a distance calculating means 140, and an antenna position setting means 150.

The means constituting the antenna setting system 100 corresponding to the procedures of the antenna setting method may be implemented manually by a worker, or all or a part of the means may be implemented automatically using an antenna setting device, for example.

The receiving means 110 receives the magnetic fields from the first antenna 13A, the second antenna 13B, and the third antenna 13C. For example, the magnetic fields generated in the first antenna 13A, the second antenna 13B, and the third antenna 13C by the control unit 12 are received by the receiving TAG 21.

The calibration origin setting means 120 sets, based on the reception strengths from the second antenna 13B and the third antenna 13C received by the receiving means 110, an intermediate position at which the reception strengths from the second antenna 13B and the third antenna 13C are equal as a calibration origin. For example, on a straight line connecting the second antenna 13B and the third antenna 13C, a position at which the reception strengths from the second antenna 13B and the third antenna 13C received by the receiving TAG 21 are equal is set as the calibration origin.

The antenna installing means 130 moves the receiving TAG 21 from the calibration origin set by the calibration origin setting means 120 and installs, based on the reception strengths from the second antenna 13B and the third antenna 13C received by the receiving TAG 21, the first antenna 13A at a position (first position) at which the distances from the second antenna 13B and the third antenna 13C are equal. For example, the receiving TAG 21 may be moved from the calibration origin in a direction substantially orthogonal to (so as to be orthogonal to) the straight line connecting the second antenna 13B and the third antenna 13C, and a position at which the reception strengths from the second antenna 13B and the third antenna 13C received by the receiving TAG 21 are equal may be specified in the vicinity of a position at which the first antenna 13A is installed (position to be installed), and thus the first antenna 13A may be installed.

The distance calculating means 140 moves (installs) the receiving TAG 21 to the calibration origin and calculates, based on the reception strengths from the first antenna 13A, the second antenna 13B, and the third antenna 13C, a first distance from the calibration origin to the first antenna 13A, a second distance from the calibration origin to the second antenna 13B, and a third distance from the calibration origin to the third antenna 13C. For example, the first distance, the second distance, and the third distance are calculated by the reception strengths from the first antenna 13A, the second antenna 13B, and the third antenna 13C, respectively, received by the receiving TAG 21 at the calibration origin based on the characteristic that the magnetic field strength (RSSI) attenuates with the cube of the distance.

The antenna position setting means 150 sets, based on the first distance, the second distance, and the third distance calculated by the distance calculating means 140, the positions at which the first antenna 13A, the second antenna 13B, and the third antenna 13C are installed. For example, the antenna position setting means 150 may register the coordinate data of the installation positions of the first antenna 13A, the second antenna 13B, and the third antenna 13C as the coordinates in an XYZ-coordinate system, with the calibration origin as an origin of the XYZ-coordinate system.

### State of Setting Antenna

FIG. 3 is a diagram illustrating a state in which the intermediate position at which the reception strengths from the second antenna 13B and the third antenna 13C are equal is set as a calibration origin O. As illustrated in FIG. 3, by using the receiving TAG 21, the position at which the reception strengths from the second antenna 13B and the third antenna 13C received by the receiving TAG 21 are equal is set as the calibration origin O that is the intermediate position between the second antenna 13B and the third antenna 13C. That is, a second distance d2 from the calibration origin O to the second antenna 13B is equal to a third distance d3 from the calibration origin O to the third antenna 13C.

To be specific, on the straight line connecting the second antenna 13B and the third antenna 13C, the position at which the reception strengths from the second antenna 13B and the third antenna 13C received by the receiving TAG 21 are equal may be searched for. That is, a position at which the reception strengths from the second antenna 13B and the third antenna 13C received by the receiving TAG 21 are equal and minimal is set as the calibration origin O.

As the calibration origin setting means 120, a worker may search for the intermediate positions at which the reception strengths from the second antenna 13B and the third antenna 13C are equal while moving the receiving TAG 21, or the antenna setting device that automatically searches for a part or all of the intermediate positions may be used. The antenna setting device may include, for example, a linear shape rail connecting the second antenna 13B and the third antenna 13C, and may search for the position at which the reception strengths from the second antenna 13B and the third antenna 13C received by the receiving TAG 21 are equal while moving the receiving TAG 21 on the rail.

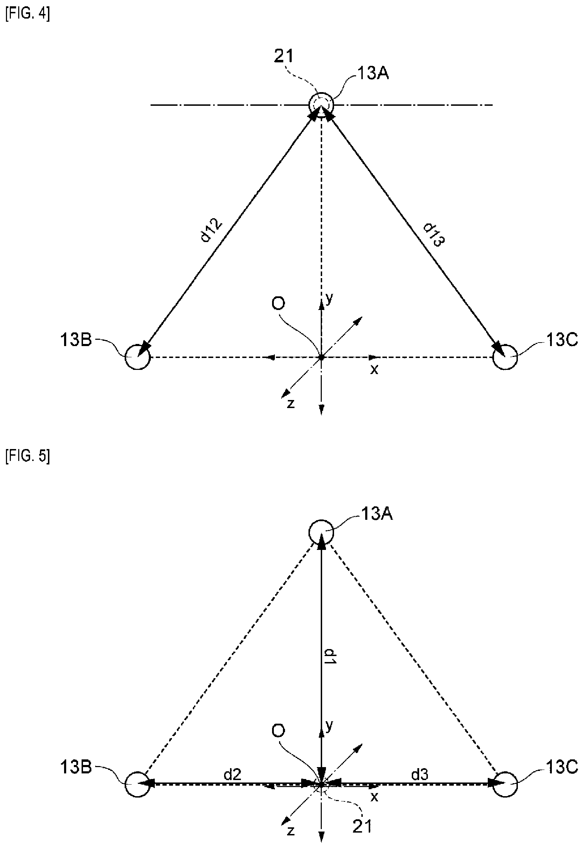

FIG. 4 is a diagram illustrating a state in which the first antenna 13A is installed at the position at which distances from the second antenna 13B and the third antenna 13C are equal. As illustrated in FIG. 4, the receiving TAG 21 is moved from the calibration origin O, the position (first position) at which the reception strengths from the second antenna 13B and the third antenna 13C received by the receiving TAG 21 are equal is specified in the vicinity of the position at which the first antenna 13A is installed (position to be installed), thereby installing the first antenna 13A. That is, a distance d12 from the first antenna 13A to the second antenna 13B is equal to a distance d13 from the first antenna 13A to the third antenna 13C.

To be specific, as the antenna installing means 130, the position at which the reception strengths from the second antenna 13B and the third antenna 13C received by the receiving TAG 21 are equal may be searched for while moving the receiving TAG 21 in parallel with the straight line connecting the second antenna 13B and the third antenna 13C. The calibration origin O is at the intermediate position between the second antenna 13B and the third antenna 13C, and the distance d12 from the first antenna 13A to the second antenna 13B is equal to the distance d13 from the first antenna 13A to the third antenna 13C, and thus a straight line connecting the calibration origin O and the first antenna 13A is a perpendicular bisector of an isosceles triangle formed by the first antenna 13A, the second antenna 13B, and the third antenna 13C. That is, the straight line connecting the calibration origin O and the first antenna 13A is orthogonal to the straight line connecting the second antenna 13B and the third antenna 13C.

As the antenna installing means 130, a worker may search for positions at which the distances from the second antenna 13B and the third antenna 13C are equal while moving the receiving TAG 21, or the antenna setting device that automatically searches for a part or all of the positions may be used. The antenna setting device may include, for example, a linear rail parallel to the straight line connecting the second antenna 13B and the third antenna 13C, and may search for the positions at which the reception strengths from the second antenna 13B and the third antenna 13C received by the receiving TAG 21 are equal while moving the receiving TAG 21 on the rail.

FIG. 5 is a diagram illustrating a state in which the first distance d1 to the first antenna 13A from the calibration origin O, the second distance d2 to the second antenna 13B from the calibration origin O, and the third distance d3 to the third antenna 13C from the calibration origin O are calculated. As illustrated in FIG. 5, the receiving TAG 21 is set at the calibration origin O, and the distance calculating means 140 calculates, based on the reception strengths from the first antenna 13A, the second antenna 13B, and the third antenna 13C received by the receiving TAG 21, the first distance d1, the second distance d2, and the third distance d3.

To be specific, the distance calculating means 140 calculates, based on the characteristic that the magnetic field strength (RSSI) attenuates with the cube of the distance, the first distance d1, the second distance d2, and the third distance d3 by the reception strengths from the first antenna 13A, the second antenna 13B, and the third antenna 13C, respectively, received by the receiving TAG 21 at the calibration origin O.

Then, the antenna position setting means 150 may set the X-axis along the straight line connecting the second antenna 13B and the third antenna 13C with the calibration origin O as the origin of the XYZ-coordinate system and register, based on the second distance d2 and the third distance d3, the second antenna 13B and the third antenna 13C as the coordinates in the XYZ-coordinate system. The antenna position setting means 150 may set the Y-axis in the direction from the calibration origin O toward the first antenna 13A and register, based on the first distance d1, the first antenna 13A as the coordinate in the XYZ-coordinate system.

### Flow of Processing of Antenna Setting Method

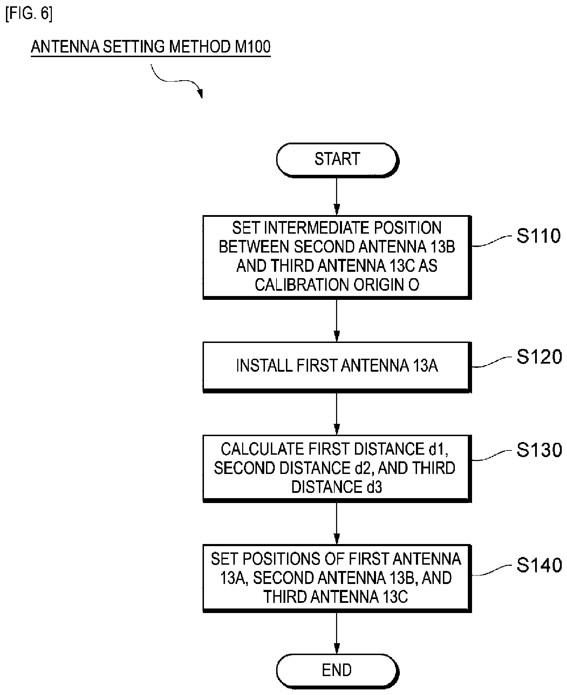

FIG. 6 is a flowchart illustrating a flow of processing of an antenna setting method M100 according to the first embodiment of the present invention. As illustrated in FIG. 6, the antenna setting method M100 includes steps S110 to S140, and each step is executed by the antenna setting system 100. To be specific, each step is executed manually by a worker and/or automatically by an antenna installation device, by using the receiving TAG 21 that can receive the magnetic field strengths from the first antenna 13A, the second antenna 13B, and the third antenna 13C constituting the positioning system 1.

In step S110, on the straight line connecting the second antenna 13B and the third antenna 13C, the calibration origin setting means 120 sets, as the calibration origin O, the position at which the reception strengths from the second antenna 13B and the third antenna 13C received by the receiving TAG 21 are equal as the intermediate position between the second antenna 13B and the third antenna 13C (first step).

In step S120, the antenna installing means 130 moves the receiving TAG 21 from the calibration origin O, specifies the position (first position) at which the reception strengths from the second antenna 13B and the third antenna 13C received by the receiving TAG 21 are equal and installs the first antenna 13A (second step).

In step S130, the receiving TAG 21 is installed at the calibration origin O, and the distance calculating means 140 calculates the first distance d1, the second distance d2, and the third distance d3 by the reception strengths from the first antenna 13A, the second antenna 13B, and the third antenna 13C, respectively, received by the receiving TAG 21 (third step).

In step S140, the antenna position setting means 150 registers, based on the first distance d1, the second distance d2, and the third distance d3 with the calibration origin O as the origin of the XYZ-coordinate system, the coordinate data of the installation positions of the first antenna 13A, the second antenna 13B, and the third antenna 13C as the coordinates in the XYZ-coordinate system.

In this way, by associating the first antenna 13A, the second antenna 13B, and the third antenna 13C set on the XYZ-coordinate system with the calibration origin O as the origin with three dimensional coordinates in a real space, the target equipped with the receiving TAG 21 in the real space can be appropriately positioned.

As described above, according to the antenna setting system 100 and the antenna setting method M100 according to the first embodiment of the present invention, the intermediate position at which the reception strengths from the second antenna 13B and the third antenna 13C are equal is set as the calibration origin O based on the magnetic field strengths received by the receiving TAG 21, the receiving TAG 21 is moved from the calibration origin O, the first antenna 13A is installed at the first position at which the distances from the second antenna 13B and the third antenna 13C are equal based on the magnetic field strengths received by the receiving TAG 21, the receiving TAG 21 is further installed at the calibration origin O, the first distance d1, the second distance d2, and the third distance d3 are calculated based on the magnetic field strengths received by the receiving TAG 21, and the coordinate data of the installation positions of the first antenna 13A, the second antenna 13B, and the third antenna 13C are set based on these distances. That is, the coordinate data of the installation positions of the first antenna 13A, the second antenna 13B, and the third antenna 13C can be appropriately set based on the distances calculated based on the magnetic field strengths received by the receiving TAG 21. As a result, in the positioning system 1 including the first antenna 13A, the second antenna 13B, and the third antenna 13C, unlike the coordinate data of the installation position based on the physically measured distances, the position of the source of the magnetic field is set from the distance calculated based on the magnetic field strength received from each antenna, thereby positioning the target equipped with the receiving TAG 21 with high accuracy.

In the present embodiment, the magnetic fields are generated from the first antenna 13A, the second antenna 13B, and the third antenna 13C, and the distances to the first antenna 13A, the second antenna 13B, and the third antenna 13C are calculated based on the magnetic field strengths received by the receiving TAG 21, but the embodiment is not limited thereto. For example, radio waves may be used, and radio wave signals may be transmitted from the first antenna 13A, the second antenna 13B, and the third antenna 13C, and the distances to the first antenna 13A, the second antenna 13B, and the third antenna 13C may be calculated based on the radio wave strengths received by the receiving TAG 21.

### Second Embodiment

Next, in a second embodiment of the present invention, a method for confirming the coordinate data of the installation positions of the first antenna 13A, the second antenna 13B, and the third antenna 13C set using the antenna setting method described in the first embodiment will be described.

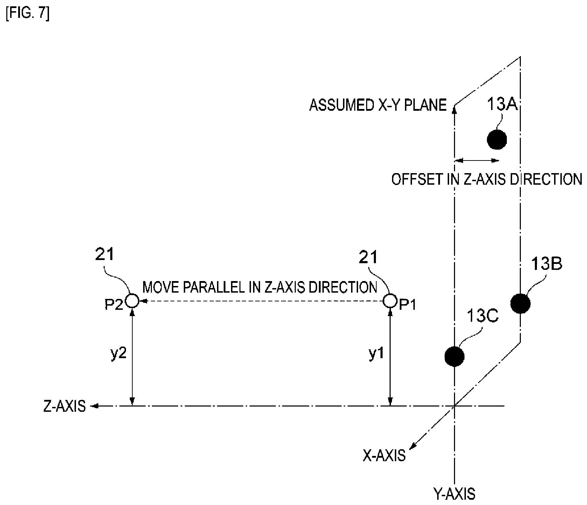

FIG. 7 is a diagram illustrating a state in which the target equipped with the receiving TAG 21 is positioned using the first antenna 13A, the second antenna 13B, and the third antenna 13C. As illustrated in FIG. 7, it is assumed that the Z-axis is set horizontally, and the first antenna 13A, the second antenna 13B, and the third antenna 13C are set on an X-Y plane.

As a specific example, on a table horizontally installed along the Z-axis, the target equipped with the receiving TAG 21 is moved in parallel from a position P1 to a position P2. In this case, the target equipped with the receiving TAG 21 is positioned using the first antenna 13A, the second antenna 13B, and the third antenna 13C (fifth step), and a height position (y1) at the position P1 and a height position (y2) at the position P2 are determined (sixth step).

When y1 = y2 is satisfied, it is determined that the position set as the coordinate data of the installation position of the first antenna 13A is set appropriately (sixth step).

On the other hand, when y1 = y2 is not satisfied, it is determined that the position set as the coordinate data of the installation position of the first antenna 13A is set to be deviated (sixth step), and the position is offset in the Z-axis direction (seventh step).

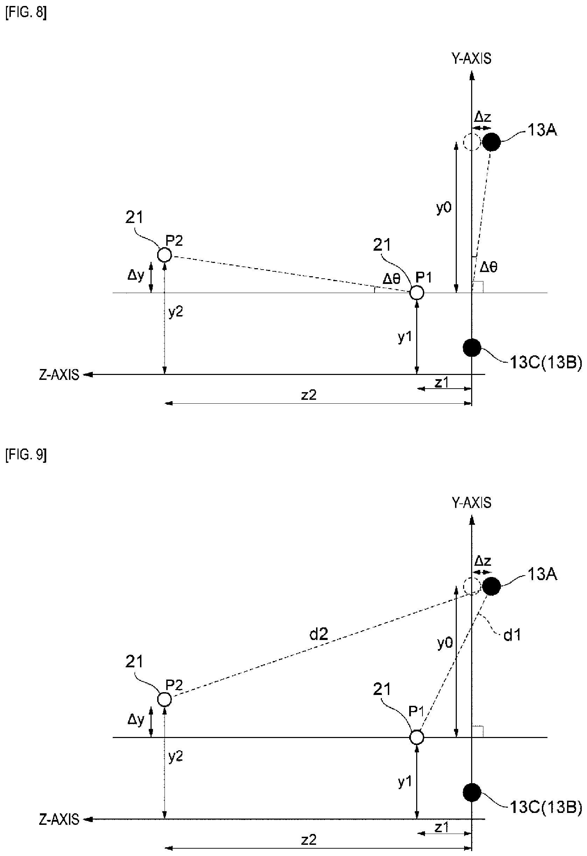

FIG. 8 is a diagram illustrating a specific example in which the coordinate data of the installation position of the first antenna 13A set using the antenna setting method described in the first embodiment are offset in the Z-axis direction. As illustrated in FIG. 8, when the target equipped with the receiving TAG 21 is moved in parallel from the position P1 to the position P2, the height position (y1) at the position P1 and the height position (y2) at the position P2 are different from each other, which is the positioning result at this time.

For example, in the receiving TAG 21 that has been positioned, when a Z coordinate position at the position P1 is z1, a Z coordinate position at the position P2 is z2, a difference in height position between the position P1 and the position P2 is Δy = y2 - y1, and an angle thereof is Δθ, an offset amount Δz of the first antenna 13A (Y coordinate position y0) in the Z-axis direction can be calculated using the following (Math. 1) and (Math. 2). [Math. 1] $Δ θ = {tan}^{- 1} \left(\frac{{z}_{2} - {z}_{1}}{Δ y}\right)$ [Math. 2] $Δ z = tan Δ θ \times {y}_{0}$

In FIG. 8, two right triangles having the angle Δθ are formed. Using the similarity relationship between the two right triangles, an offset amount Δz of the first antenna 13A (Y coordinate position y0) in the Z-axis direction can be calculated using the following (Math. 3) and (Math. 4). [Math. 3] $\frac{Δ z}{{y}_{0}} = \frac{Δ y}{{z}_{2} - {z}_{1}}$ [Math. 4] $Δ z = \frac{Δ y}{{z}_{2} - {z}_{1}} \times {y}_{0}$

The method for calculating the offset amount Δz of the first antenna 13A (Y coordinate position y0) in the Z-axis direction is not limited thereto.

FIG. 9 is a diagram illustrating another specific example in which the coordinate data of the installation position of the first antenna 13A set using the antenna setting method described in the first embodiment are offset in the Z-axis direction. As illustrated in FIG. 9, for example, from the coordinate data of the installation position of the first antenna 13A, when the distance to the position P1 is represented by the d1 and the distance to the position P2 is represented by the d2 in the receiving TAG 21 that has been positioned, the offset amount Δz of the first antenna 13A (Y coordinate position y0) in the Z-axis direction can be calculated using the following (Math. 5), (Math. 6), and (Math. 7). [Math. 5] ${\left({z}_{1}+Δz\right)}^{2} + {y}_{0}^{2} = {d}_{1}^{2}$ [Math. 6] ${\left({z}_{2}+Δz\right)}^{2} + {\left({y}_{0}-Δy\right)}^{2} = {d}_{2}^{2}$ [Math. 7] $Δ z = \frac{\sqrt{{d}_{1}^{2} - {y}_{0}^{2}} + \sqrt{{d}_{2}^{2} - {\left({y}_{0}-Δy\right)}^{2}} - {z}_{1} - {z}_{2}}{2}$

As described above, according to the method for confirming the coordinate data of the installation positions of the first antenna 13A, the second antenna 13B, and the third antenna 13C according to the second embodiment of the present invention, the target equipped with the receiving TAG 21 is positioned at two points (the position P1 and the position P2) having different positions in the Z-axis direction orthogonal to an assumed X-Y plane including the first antenna 13A, the second antenna 13B, and the third antenna 13C. The deviation of the position set as the coordinate data of the installation position of the first antenna 13A is determined based on the height position (y1) at the position P1 and the height position (y2) at the position P2, thereby appropriately confirming the accuracy of the coordinate data of the installation positions of the first antenna 13A, the second antenna 13B, and the third antenna 13C.

When it is determined that the position set as the coordinate data of the installation position of the first antenna 13A is set to be deviated, as described with reference to FIGS. 7 and 8, the offset amount Δz in the Z-axis direction can be appropriately calculated as the coordinate data of the installation position of the first antenna 13A. As a result, the coordinate data of the installation positions of the first antenna 13A, the second antenna 13B, and the third antenna 13C can be set more appropriately, and the target equipped with the receiving TAG 21 can be positioned more accurately using the coordinate data.

In the above description, the position in the Z-axis direction set as the coordinate data of the installation position of the first antenna 13A is confirmed and is offset, but the embodiment is not limited thereto. For example, the target equipped with the receiving TAG 21 is moved in parallel on a table horizontally placed along the X-axis. In this case, the target equipped with the receiving TAG 21 is positioned using the first antenna 13A, the second antenna 13B, and the third antenna 13C, and the height positions at two different points are compared. Thus, the deviation of the positions in the Z-axis direction set as the coordinate data of the installation positions of the second antenna 13B and the third antenna 13C can be confirmed.

The above-described embodiment is provided for facilitating understanding of the present invention and is not intended to limit the interpretation of the present invention. Each element included in each embodiment as well as the arrangement, material, condition, shape, size, and the like of each element are not limited to those exemplified and may be changed appropriately. The configurations described in different embodiments can be partially replaced or combined.

### Supplementary Note

An antenna setting method (M100) for setting a first antenna (13A), a second antenna (13B), and a third antenna (13C) used in a positioning system (1), the antenna setting method (M100) including:
a first step (S110) of setting, based on reception strengths from the second antenna (13B) and the third antenna (13C) received by a sensor device (21), an intermediate position at which the reception strengths from the second antenna (13B) and the third antenna (13C) are equal as a calibration origin (O);
a second step (S120) of moving the sensor device (21) from the calibration origin (O) and installing, based on the reception strengths from the second antenna (13B) and the third antenna (13C) received by the sensor device (21), the first antenna (13A) at a first position at which distances from the second antenna (13B) and the third antenna (13C) are equal;
a third step (S130) of moving the sensor device (21) to the calibration origin (O) and calculating, based on the reception strengths from the first antenna (13A), the second antenna (13B), and the third antenna (13C), a first distance (d1) from the calibration origin (O) to the first antenna (13A), a second distance (d2) from the calibration origin (O) to the second antenna (13B), and a third distance (d3) from the calibration origin (O) to the third antenna (13C); and
a fourth step (S140) of setting, based on the first distance (d1), the second distance (d2), and the third distance (d3), coordinate data of installation positions of the first antenna (13A), the second antenna (13B), and the third antenna (13C).

### REFERENCE SIGNS

1 Positioning system, 11, 22 PC, 12 Control unit, 13A to 13C Antenna, 21 Receiving TAG (sensor device), 100 Antenna setting system, 110 Receiving means, 120 Calibration origin setting means, 130 Antenna installing means, 140 Distance calculating means, 150 Antenna position setting means, M100 Antenna setting method, S110 to S140 Each step of antenna setting method M100

## Claims

1. An antenna setting method for setting a first antenna, a second antenna, and a third antenna used in a positioning system, the antenna setting method comprising:
a first step of setting, based on reception strengths from the second antenna and the third antenna received by a sensor device, an intermediate position at which the reception strengths from the second antenna and the third antenna are equal as a calibration origin;
a second step of moving the sensor device from the calibration origin and installing, based on the reception strengths from the second antenna and the third antenna received by the sensor device, the first antenna at a first position at which distances from the second antenna and the third antenna are equal;
a third step of moving the sensor device to the calibration origin and calculating, based on the reception strengths from the first antenna, the second antenna, and the third antenna, a first distance from the calibration origin to the first antenna, a second distance from the calibration origin to the second antenna, and a third distance from the calibration origin to the third antenna; and
a fourth step of setting, based on the first distance, the second distance, and the third distance, coordinate data of installation positions of the first antenna, the second antenna, and the third antenna.

2. The antenna setting method according to claim 1, wherein the first step comprises setting a position at which the reception strengths from the second antenna and the third antenna received by the sensor device are equal and minimal as the calibration origin.

3. The antenna setting method according to claim 1, wherein the second step comprises searching for the first position while moving the sensor device in a direction orthogonal to a straight line connecting the second antenna and the third antenna.

4. The antenna setting method according to claim 1, further comprising:
assuming that the first antenna, the second antenna, and the third antenna are installed at the coordinate data of the installation positions set in the fourth step, a fifth step of positioning a target equipped with the sensor device at two different points in a direction orthogonal to an assumed plane including the first antenna, the second antenna, and the third antenna; and
a sixth step of determining, based on position information of the two different points positioned in the fifth step, a deviation of the coordinate data of the installation position set as the position at which the first antenna is installed.

5. The antenna setting method according to claim 4, further comprising
when it is determined that there is a deviation in the coordinate data of the installation position set as the position at which the first antenna is installed in the sixth step, a seventh step of correcting, based on the position information of the two different points positioned in the fifth step, a direction orthogonal to the assumed plane in the coordinate data of the installation position set as the position at which the first antenna is installed.

6. The antenna setting method according to claim 1, further comprising:
assuming that the first antenna, the second antenna, and the third antenna are installed at the coordinate data of the installation positions set in the fourth step, a fifth step of positioning a target equipped with the sensor device at two different points in a direction parallel to an assumed plane including the first antenna, the second antenna, and the third antenna; and
a sixth step of determining, based on position information of the two different points positioned in the fifth step, a deviation of the coordinate data of the installation positions set as the positions at which the second antenna and the third antenna are installed.

7. The antenna setting method according to claim 6, further comprising
when it is determined that there is a deviation in the coordinate data of the installation position set as the positions at which the second antenna and the third antenna are installed in the sixth step, a seventh step of correcting, based on the position information of the two different points positioned in the fifth step, a direction orthogonal to the assumed plane in the coordinate data of the installation position set as the positions at which the second antenna and the third antenna are installed.

8. The antenna setting method according to claim 1, wherein
the first antenna, the second antenna, and the third antenna each include a coil configured to generate a magnetic field, and
the sensor device includes a coil capable of receiving magnetic fields generated by the first antenna, the second antenna, and the third antenna.

9. A positioning system configured to position a target equipped with a sensor device capable of receiving radio waves or magnetic fields from the first antenna, the second antenna, and the third antenna set by the antenna setting method according to any one of claims 1 to 8.
